# EUROPEAN PATENT SPECIFICATION

(11) **EP 4 215 928 B1**
(45) Date of publication and mention of the grant of the patent: **08.01.2025**
(21) Application number: 22152170.1
(22) Date of filing: 19.01.2022
(51) Int. Cl.: G01R 33/44, G01R 33/60, G01R 29/08, G06N 3/067, G01R 23/17, G01R 33/32, G01R 33/26, G02B 27/42

(54) **MICROWAVE SIGNAL ANALYSIS BASED ON OPTICAL PRE-PROCESSING AND QUANTUM SENSING**
MIKROWELLENSIGNALANALYSE BASIEREND AUF OPTISCHER VORVERARBEITUNG UND QUANTENMESSUNG
ANALYSE DE SIGNAUX MICRO-ONDES BASÉE SUR UN PRÉTRAITEMENT OPTIQUE ET UNE DÉTECTION QUANTIQUE

(43) Date of publication of application: 26.07.2023
(73) Proprietor: Rohde & Schwarz GmbH & Co. KG, 81671 München (DE)
(72) Inventor: Guezelarslan, Baris, 85521 Ottobrunn (DE); Ruster, Thomas, 81543 Munich (DE); Ho, Melvyn, 81541 Munich (DE)
(74) Representative: Novagraaf Group

(56) References cited:
- EP-A1- 3 588 117
- EP-A1- 3 809 145
- US-A- 3 513 381
- STÜRNER FELIX M ET AL: "Compact integrated magnetometer based on nitrogen-vacancy centres in diamond", DIAMOND AND RELATED MATERIALS, vol. 93, 17 January 2019 (2019-01-17), pages 59 - 65, XP085642093, ISSN: 0925-9635, DOI: 10.1016/J.DIAMOND.2019.01.008
- LIN XING ET AL: "All-optical machine learning using diffractive deep neural networks", SCIENCE, vol. 361, no. 6406, 7 September 2018 (2018-09-07), US, pages 1004 - 1008, XP055933107, ISSN: 0036-8075, DOI: 10.1126/science.aat8084
- CETINTAS MUSTAFA: "Microwave Magnetic Field Pattern Evaluation of Horn and Patch Antennas Using Cs Atomic Sensor", IEEE SENSORS JOURNAL, IEEE, USA, vol. 21, no. 7, 20 January 2021 (2021-01-20), pages 9016 - 9022, XP011842884, ISSN: 1530-437X, [retrieved on 20210304], DOI: 10.1109/JSEN.2021.3053123

## Description

### Technical Field

The present disclosure relates to signal analysis in microwave communication, and in particular to a measurement system for real-time analysis of radio frequency (RF) signals and a corresponding method.

### Background Art

Atom-based quantum effects may be used in developing quantum sensors for various physical quantities, as is known in the art.

Detection of microwave signals based on quantum sensors often involves a read-out in an optical manner. A common setup for reading out the state of quantum sensors such as atomic vapor cells involves analyzing the transmitted power of a laser beam. Quantum sensors such as Nitrogen-vacancy (NV) diamonds are typically read out by analyzing their emitted fluorescence light.

The light pattern emanating from the quantum sensor depends on the frequency components of the analyzed microwave signal, and may be imaged with a digital camera and further transformed to identify said frequency components. For example, EP 3 809 145 A1 discloses an implementation of a measurement system for analysis of RF signals being based on a digital camera and a subsequent transformation to identify frequency components.

According to a conventional implementation, the transformation on a CPU, DSP or FPGA consumes time and electrical energy.

### Summary

The present disclosure therefore strives to improve an RF signal analysis of the background art. The objective is achieved by the embodiments as defined by the appended independent claims. Preferred embodiments are set forth in the dependent claims and in the following description and drawings.

A first aspect of the present disclosure, as defined in claim 1, relates to a measurement system for analyzing an RF signal.

The system comprises a sensing medium, including at least one constituent being pumpable to an initial energy state, and being excitable from the initial energy state to a higher energy state by exposure to an electric and/or magnetic field. The system further comprises an optical pump configured to pump the at least one constituent of the medium to the initial energy state. The system further comprises an antenna configured to expose the medium to an electromagnetic field of the RF signal. The system further comprises an optical processor configured to apply a linear transformation to light emanating from the pumped medium. The system further comprises an optical detector configured to detect an optical property of the transformed light.

The system may further comprise a field generator configured to expose the medium to a static electric or magnetic field, a strength of which defines an absorption spectrum of the medium.

The strength of the generated field may have a gradient along a spatial dimension of the medium. The field generator may comprise a permanent magnet.

The optical processor comprises a trained artificial neural network, ANN, being configured to apply the linear transformation to the light emanating from the pumped medium.

The trained ANN comprises a number of diffractive layers being arranged in series for traversal by the light emanating from the pumped medium.

The diffractive layers may be established by supervised learning with labelled training data, and additive manufacture.

The labelling of the training data may take into account one or more of: a desired output of the linear transformation; a focusing of the transformed light to the optical detector; calibration; and error correction.

The medium may comprise an alkali metal enclosed in an atomic vapor cell; and the at least one constituent of the medium may comprise atoms or ions in a buffer gas. The light emanating from the pumped medium may comprise a pump light transmission through the medium having a cross-sectional intensity distribution depending on a frequency of the electromagnetic field of the RF signal.

The medium may comprise a Nitrogen vacancy, NV, diamond; and the at least one constituent of the medium may comprise point defects. The light emanating from the pumped medium may comprise a light emission of the medium having a directional intensity distribution depending on the frequency of the electromagnetic field of the RF signal. The system may further comprise an optical lens configured to collimate the light emanating from the pumped medium onto the optical processor.

The pump may comprise at least one coherent optical light source.

The detector may comprise at least one charge-coupled device, CCD, chip or CMOS chip etc., extending across a cross-section of the transformed light; and the detected optical property may comprise a cross-sectional intensity distribution of the transformed light.

A second aspect of the present disclosure relates to a method of analyzing an RF signal. The method, which is defined in claim 12, comprises pumping at least one constituent of a sensing medium to an initial energy state. The at least one constituent is further excitable from the initial energy state to a higher energy state by exposure to an electric and/or magnetic field. The method further comprises exposing the medium to an electromagnetic field of the RF signal. The method further comprises applying a linear transformation to light emanating from the pumped medium. The method further comprises detecting an optical property of the transformed light.

### Advantageous Effects

The present disclosure provides a measurement system for analyzing RF/microwave signals which optically pre-processes the light pattern emanating from the pumped medium before it is imaged by a camera. This scheme does not consume electrical power at runtime (with regard to the optical processor), works at the speed of light, and requires no extra conversions.

It is possible to encode a trained neural network in such an optical processor ("AI lens"). The neural network may be trained to also perform tasks such as focusing the image to the optical detector, e.g. the afore-mentioned camera, or additional calibration, or error correction, yielding a multi-purpose AI lens that performs multiple tasks at once.

The technical effects and advantages described above in relation with the measurement system of the first aspect equally apply to the method of the second aspect having corresponding features.

### Brief Description of Drawings

The above-described aspects and implementations will now be explained with reference to the accompanying drawings, in which the same or similar reference numerals designate the same or similar elements.

The features of these aspects and implementations may be combined with each other unless specifically stated otherwise.

The drawings are to be regarded as being schematic representations, and elements illustrated in the drawings are not necessarily shown to scale. Rather, the various elements are represented such that their function and general purpose become apparent to those skilled in the art.
- FIG. 1: illustrates a measurement system in accordance with a first implementation for analyzing an RF signal;
- FIG. 2: illustrates a measurement system in accordance with a second implementation for analyzing an RF signal;
- FIGs. 3A-C: illustrate expected light patterns at interfaces A-A' of FIGs. 1 and 2;
- FIGs. 4A-C: illustrate desired light patterns at interfaces B-B' of FIGs. 1 and 2; and
- FIG. 5: illustrates a flow chart of a method in accordance with the present disclosure for analyzing an RF signal.

### Detailed Descriptions of Drawings

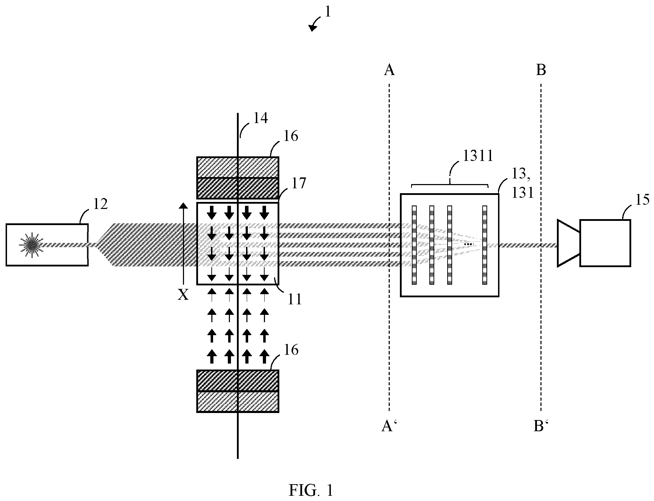

FIG. 1 illustrates a measurement system 1 in accordance with a first implementation for analyzing an RF signal.

The system 1 comprises a sensing medium 11, including at least one constituent being pumpable to an initial energy state, and being excitable from the initial energy state to a higher energy state by exposure to an electric and/or magnetic field.

In particular, the medium 11 may comprise an alkali metal - such as Rubidium - enclosed in an atomic vapor cell 17, and the at least one constituent of the medium 11 may comprise atoms or ions of the alkali metal in a buffer gas.

The system 1 further comprises an optical pump 12 configured to pump the at least one constituent of the medium 11 to the initial energy state.

The pump 12 may comprise at least one coherent optical light source.

In particular, the pump 12 may comprise a single coherent optical light source for pumping and readout of the medium 11. Alternatively, the pump 12 may comprise a first coherent optical light source for pumping and a second coherent optical light source for readout. For example, the respective coherent optical light source may comprise a laser.

The system 1 further comprises an antenna 14 configured to expose the medium 11 to an electromagnetic field of the RF signal.

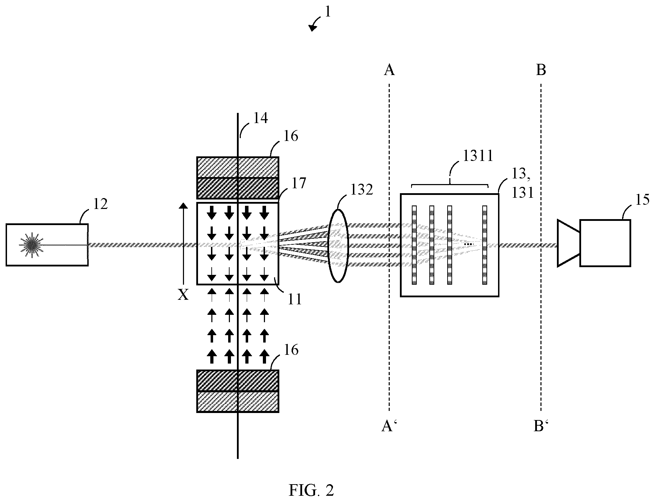

In particular, the antenna 14 may comprise a waveguide such as a metallic wire (shown in FIGs. 1 and 2) around which a near field may evolve responsive to the RF signal. Alternatively, the antenna 14 may comprise a microwave antenna (not shown) such as a reflector antenna, horn antenna, or the like. Using a single antenna ensures that a time-dependency of the RF signal under analysis is consistent across all regions of the cell.

The system 1 further comprises an optical processor 13 configured to apply a linear transformation to light emanating from the pumped medium 11. That is, the optical processor 13 is an optical element configured to manipulate a spatial distribution of the light.

In the implementation of FIG. 1, the light emanating from the pumped medium 11 may comprise a pump light transmission through the medium 11 having a cross-sectional intensity distribution depending on a frequency of the electromagnetic field of the RF signal.

The optical processor 13 may comprise a trained artificial neural network, ANN 131, being configured to apply the linear transformation to the light emanating from the pumped medium 11.

An example of such an optical processor 13 is described in "All-optical machine learning using diffractive deep neural networks" by Lin et al., Science 361, pp. 1004-1008 (2018).

The trained ANN 131 may comprise a number of diffractive layers 1311 being arranged in series for traversal by the light emanating from the pumped medium 11. The diffractive layers 1311 are microstructured diffraction surfaces which implement a linear transformation on the input light.

The diffractive layers 1311 may be established by supervised learning with labelled training data, and additive manufacture, such as 3D printing.

The labelling of the training data may take into account one or more of: a desired output of the linear transformation; a focusing of the transformed light to an optical detector 15; calibration; and error correction.

The system 1 further comprises the optical detector 15 configured to detect an optical property of the transformed light.

The detector 15 may comprise at least one charge-coupled device, CCD, chip extending across a cross-section of the transformed light. For example, if the detector 15 cannot measure continuously, it is possible to use two camera chips taking turns. The detected optical property may comprise a cross-sectional intensity distribution of the transformed light.

The system 1 may further comprise a field generator 16 configured to expose the medium 11 to a static electric or magnetic field. A strength of the generated field may define an absorption spectrum of the medium 11.

In particular, the strength of the generated field may have a gradient along a spatial dimension X of the medium 11. In FIG. 1, said spatial dimension *X* is indicated by an arrow pointing upwardly along the medium 11.

In particular, the field generator 16 may comprise a permanent magnet. For example, FIG. 1 shows a pair of oppositely aligned permanent magnets 16 whose respective magnetic fields tend to cancel each other out halfway of their spacing. As a result, the strength of the generated magnetic field has a gradient along the spatial dimension X of the medium 11.

A presence of such an inhomogeneous magnetic field may cause Zeeman splitting, which ensures availability of atoms, ions or point defects in an initial state for each frequency in a desired frequency range, which may be included in a microwave frequency range ranging between 300 MHz and 300 GHz, respectively.

Zeeman splitting may refer to splitting of a spectral line, such as the initial state, into several components in the presence of a static magnetic field. Stark splitting, the electric-field analogue of Zeeman splitting, may refer to splitting of a spectral line into several components in the presence of a static electric field.

FIG. 2 illustrates a measurement system 1 in accordance with a second implementation for analyzing an RF signal.

In the alternative implementation of FIG. 2, the medium 11 may comprise a Nitrogen vacancy, NV, diamond, and the at least one constituent of the medium 11 may comprise point defects. In this case, the light emanating from the pumped medium 11 may comprise a - fluorescent - light emission of the medium 11 having a directional intensity distribution depending on the frequency of the electromagnetic field of the RF signal.

In other words, the light emission may be divergent. As such, the system 1 may further comprise an optical lens 132 configured to collimate the light emanating from the pumped medium 11 onto the optical processor 13.

All other elements of FIG. 2 correspond to those already explained in connection with FIG. 1 and having same reference numerals.

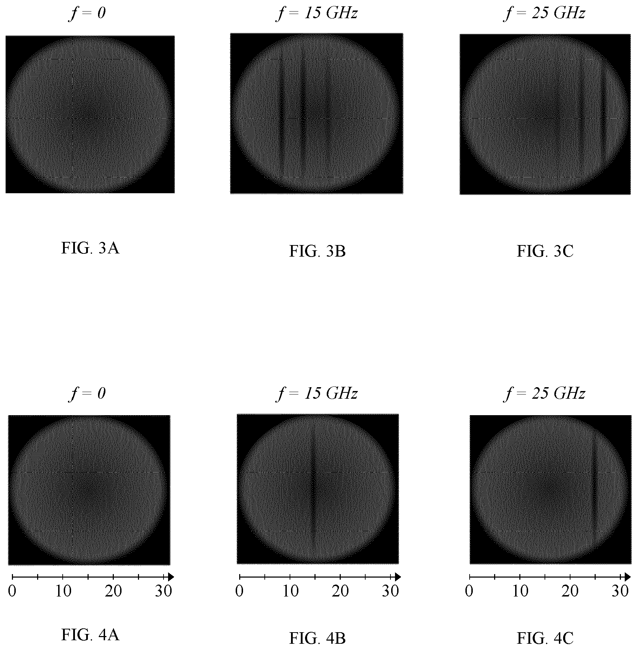

FIGs. 3A-C illustrate expected light patterns at interfaces A-A' of FIGs. 1 and 2.

FIG. 3A shows no RF signal at all (*f* = 0).

FIG. 3B shows an expected multi-component light pattern resulting from a first exemplary RF frequency component (*f* = *15 GHz*).

FIG. 3C shows an expected multi-component light pattern resulting from a second exemplary RF frequency component (*f* = *25 GHz*).

The multi-component patterns of FIG. 3B and 3C complicate an identification of the analyzed frequency components, and this would become even more difficult when analyzing multiple frequency components.

After optical processing (i.e., transformation) of the expected light patterns of FIG. 3 A-C, the detector images should ideally correspond to the light patterns of FIG. 4A-C.

FIGs. 4A-C illustrate desired light patterns at interfaces B-B' of FIGs. 1 and 2.

FIG. 4A shows no RF signal (*f* = 0), owing to a lack of frequency content.

FIG. 4B shows a desired single-component light pattern resulting from the first exemplary RF signal (*f* = *15 GHz*).

FIG. 4C shows a desired single-component light pattern resulting from the second exemplary RF signal (*f* = *25 GHz*).

FIGs. 3A-C and 4A-C represent example light patterns that may be used as labelled training data for supervised learning. More specifically, this may involve applying FIGs. 3A-C and similar light patterns one after another to an input layer of the ANN 131, obtaining resulting output light patterns at an output layer of the ANN 131, and performing a backpropagation (or similar) algorithm to train the ANN 131 based on discrepancies between pairs of output light patterns and desired light patterns.

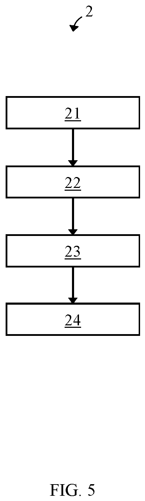

FIG. 5 illustrates a flow chart of a method 2 in accordance with the present disclosure for analyzing an RF signal.

The method 2 comprises pumping 21 at least one constituent of a sensing medium 11 to an initial energy state. The at least one constituent is further excitable from the initial energy state to a higher energy state by exposure to an electric and/or magnetic field.

The method 2 further comprises exposing 22 the medium 11 to an electromagnetic field of the RF signal.

The method 2 further comprises applying 23 a linear transformation to light emanating from the pumped medium 11.

The method 2 further comprises detecting 24 an optical property of the transformed light.

## Claims

1. A measurement system (1) for analyzing an RF signal, comprising
- a sensing medium (11), including at least one constituent
- being pumpable to an initial energy state, and
- being excitable from the initial energy state to a higher energy state by exposure to an electric and/or magnetic field;
- an optical pump (12) configured to pump the at least one constituent of the sensing medium (11) to the initial energy state;
- an antenna (14) configured to expose the sensing medium (11) to an electromagnetic field of the RF signal in order to excite it;
wherein light emanating from the pumped sensing medium (11) has a spatial distribution, which depends on the frequency of the RF signal;
the measurement system (1) further comprising:
- an optical processor (13) comprising a trained diffractive deep neural network being an artificial neural network, ANN (131), that comprises a number of diffractive layers (1311) being arranged in series for traversal by the light emanating from the pumped medium (11), and that is configured to manipulate the spatial distribution of the light such as to apply a linear transformation to the light emanating from the pumped sensing medium (11),
wherein the ANN (131) is trained based on discrepancies between pairs of output light patterns and desired light patterns; and
- an optical detector (15) configured to detect an optical property of the transformed light.

2. The system of claim 1,
wherein the light emanating from the sensing medium (11) is pump light from the optical pump or probing light from another light source, respectively passing through or reflected by the sensing medium (11).

3. The system (1) of claim 1 or 2, further comprising
a field generator (16) configured to expose the medium (11) to a static electric or magnetic field, a strength of which defining an absorption spectrum of the medium (11).

4. The system (1) of any of the preceding claims,
the strength of the generated field having a gradient along a spatial dimension (X) of the medium (11).

5. The system (1) of claim 4,
the field generator (16) comprising a permanent magnet.

6. The system (1) of any one of the claims 1 to 5,
the diffractive layers (1311) being established by supervised learning with labelled training data, and additive manufacture.

7. The system (1) of claim 6,
the labelling of the training data taking into account one or more of:
- a desired output of the linear transformation;
- a focusing of the transformed light to the optical detector (15);
- calibration; and
- error correction.

8. The system (1) of any one of the claims 1 to 6,
the medium (11) comprising an alkali metal enclosed in an atomic vapor cell (17);
the at least one constituent of the medium (11) comprising atoms or ions in a buffer gas; and
the light emanating from the pumped medium (11) comprising a light transmission through the medium (11) having a cross-sectional intensity distribution depending on a frequency of the electromagnetic field of the RF signal.

9. The system (1) of any one of the claims 1 to 6,
the medium (11) comprising a Nitrogen vacancy, NV, diamond;
the at least one constituent of the medium (11) comprising point defects;
the light emanating from the pumped medium (11) comprising a light emission of the medium (11) having a directional intensity distribution depending on the frequency of the electromagnetic field of the RF signal; and
the system (1) further comprising an optical lens (132) configured to collimate the light emanating from the pumped medium (11) onto the processor (13).

10. The system (1) of any one of the preceding claims,
the pump (12) comprising at least one coherent optical light source.

11. The system (1) of any one of the preceding claims,
the detector (15) comprising at least one charge-coupled device, CCD, chip or CMOS chip, extending across a cross-section of the transformed light; and
the detected optical property comprising a cross-sectional intensity distribution of the transformed light.

12. A method (2) of analyzing an RF signal, comprising
- pumping (21) at least one constituent of a sensing medium (11) to an initial energy state, the at least one constituent further being excitable from the initial energy state to a higher energy state by exposure to an electric and/or magnetic field;
- exposing (22) the medium (11) to an electromagnetic field of the RF signal;
wherein light emanating from the pumped sensing medium (11) has a spatial distribution, which depends on the frequency of the RF signal;
- applying (23) a linear transformation to light emanating from the pumped medium (11) by means of an optical processor (13) comprising a trained diffractive deep neural network being an artificial neural network, ANN (131), that comprises a number of diffractive layers (1311) being arranged in series for traversal by the light emanating from the pumped medium (11), and that is configured to manipulate the spatial distribution of the light such as to apply a linear transformation to the light emanating from the pumped sensing medium (11),
wherein the ANN (131) is trained based on discrepancies between pairs of output light patterns and desired light patterns; and
- detecting (24) an optical property of the transformed light.

## Patentansprüche

1. Messsystem (1) zum Analysieren eines HF-Signals, umfassend
- ein Sensormedium (11), einschließlich mindestens eines Bestandteils
- wobei er in einen anfänglichen Energiezustand pumpbar ist und
- durch Aussetzung einem elektrischen und/oder magnetischen Feld von einem anfänglichen Energiezustand in einen höheren Energiezustand erregbar ist;
- eine optische Pumpe (12), die konfiguriert ist, um den mindestens einen Bestandteil des Sensormediums (11) in den anfänglichen Energiezustand zu pumpen;
- eine Antenne (14), die konfiguriert ist, um das Sensormedium (11) einem elektromagnetischen Feld des HF-Signals auszusetzen, um ihn zu erregen;
wobei das Licht, das von dem gepumpten Sensormedium (11) austritt, eine räumliche Verteilung, die von der Frequenz des HF-Signals abhängt, aufweist;
das Messsystem (1) ferner umfassend:
- einen optischen Prozessor (13), umfassend ein trainiertes diffraktives tiefes neuronales Netz, das ein künstliches neuronales Netz, ANN (131) ist, das eine Anzahl von diffraktiven Schichten (1311), die in Reihe für ein Durchqueren des Lichts, das von dem gepumpten Medium (11) austritt, angeordnet sind, umfasst, und das konfiguriert ist, um die räumliche Verteilung des Lichts zu manipulieren, um eine lineare Transformation auf das Licht, das von dem gepumpten Sensormedium (11) austritt, anzuwenden, wobei das ANN (131) basierend auf Diskrepanzen zwischen Paaren von Ausgabelichtmustern und gewünschten Lichtmustern trainiert wird; und
- einen optischen Detektor (15), der konfiguriert ist, um eine optische Eigenschaft des transformierten Lichts zu detektieren.

2. System nach Anspruch 1,
wobei das Licht, das von dem Sensormedium (11) austritt, Pumplicht von der optischen Pumpe oder Prüflicht von einer anderen Lichtquelle ist, das jeweils durch das Sensormedium (11) hindurchgeht oder von diesem reflektiert wird.

3. System (1) nach Anspruch 1 oder 2, ferner umfassend
einen Feldgenerator (16), der konfiguriert ist, um das Medium (11) einem statischen elektrischen oder magnetischen Feld auszusetzen, dessen Stärke ein Absorptionsspektrum des Mediums (11) definiert.

4. System (1) nach einem der vorstehenden Ansprüche,
wobei die Stärke des erzeugten Felds einen Gradienten entlang einer räumlichen Dimension (X) des Mediums (11) aufweist.

5. System (1) nach Anspruch 4,
der Feldgenerator (16) umfassend einen Permanentmagneten.

6. System (1) nach einem der Ansprüche 1 bis 5,
wobei diffraktiven Schichten (1311) durch überwachtes Lernen mit gekennzeichneten Trainingsdaten und additive Fertigung erstellt werden.

7. System (1) nach Anspruch 6,
wobei die Kennzeichnung der Trainingsdaten eine oder mehrere berücksichtigt von:
- einer gewünschten Ausgabe der linearen Transformation;
- einer Fokussierung des transformierten Lichts auf den optischen Detektor (15);
- einer Kalibrierung; und
- einer Fehlerkorrektur.

8. System (1) nach einem der Ansprüche 1 bis 6,
das Medium (11) umfassend ein Alkalimetall, das in einer Atomdampfzelle (17) eingeschlossen ist;
der mindestens eine Bestandteil des Mediums (11) umfassend Atome oder Ionen in einem Puffergas; und das Licht, das von dem gepumpten Medium (11) austritt, umfassend eine Lichtdurchlässigkeit durch das Medium (11), die eine Querschnittsintensitätsverteilung, die von einer Frequenz des elektromagnetischen Felds des HF-Signals abhängt, aufweist.

9. System (1) nach einem der Ansprüche 1 bis 6,
das Medium (11) umfassend einen Diamanten mit Stickstoffvalenz, NV;
der mindestens eine Bestandteil des Mediums (11) umfassend Punktdefekte;
das Licht, das von dem gepumpten Medium (11) austritt, umfassend eine Lichtemission des Mediums (11), die eine gebündelte Intensitätsverteilung, die von des Frequenz des elektromagnetischen Felds des HF-Signals abhängt, aufweist; und
das System (1) ferner umfassend eine optische Linse (132), die konfiguriert ist, um das Licht, das von dem gepumpten Medium (11) austritt, auf den Prozessor (13) zu kollimieren.

10. System (1) nach einem der vorstehenden Ansprüche,
die Pumpe (12) umfassend mindestens eine kohärente optische Lichtquelle.

11. System (1) nach einem der vorstehenden Ansprüche,
der Detektor (15) umfassend mindestens einen Chip mit ladungsgekoppeltem Bauelement, CCD, oder einen CMOS-Chip, der sich über einen Querschnitt des transformierten Lichts erstreckt; und
die detektierte optische Eigenschaft umfassend eine Querschnittsintensitätsverteilung des transformierten Lichts.

12. Verfahren (2) zum Analysieren eines HF-Signals, umfassend
- Pumpen (21) mindestens eines Bestandteils eines Sensormediums (11) in einen anfänglichen Energiezustand, wobei der mindestens eine Bestandteil ferner durch Aussetzung einem elektrischen und/oder magnetischen Feld von dem anfänglichen Energiezustand in einen höheren Energiezustand erregbar ist;
- Aussetzen (22) des Mediums (11) einem elektromagnetischen Feld des HF-Signals;
wobei das Licht, das von dem gepumpten Sensormedium (11) austritt, eine räumliche Verteilung, die von der Frequenz des HF-Signals abhängt, aufweist;
- Anwenden (23) einer linearen Transformation auf Licht, das von dem gepumpten Medium (11) austritt, mittels eines optischen Prozessors (13), umfassend ein trainiertes diffraktives tiefes neuronales Netz, das ein künstliches neuronales Netz, ANN (131) ist, das eine Anzahl von diffraktiven Schichten (1311), die in Reihe für das Durchqueren des Lichts, das von dem gepumpten Medium (11) austritt, angeordnet sind, umfasst, und das konfiguriert ist, um die räumliche Verteilung des Lichts zu manipulieren, um eine lineare Transformation auf das Licht, das von dem gepumpten Sensormedium (11) austritt, anzuwenden, wobei das ANN (131) basierend auf Diskrepanzen zwischen Paaren von Ausgabelichtmustern und gewünschten Lichtmustern trainiert wird; und
- Detektieren (24) einer optischen Eigenschaft des transformierten Lichts.

## Revendications

1. Système de mesure (1) permettant d'analyser un signal RF, comprenant
- un milieu de captage (11), comportant au moins un constituant
- pouvant être pompé jusqu'à un état énergétique initial, et
- pouvant être excité de l'état énergétique initial à un état énergétique supérieur par exposition à un champ électrique et/ou magnétique ;
- une pompe optique (12) configurée pour pomper l'au moins un constituant du milieu de captage (11) jusqu'à l'état énergétique initial ;
- une antenne (14) configurée pour exposer le milieu de captage (11) à un champ électromagnétique du signal RF afin de l'exciter ;
dans lequel de la lumière émanant du milieu de captage pompé (11) a une distribution spatiale, qui dépend de la fréquence du signal RF ;
le système de mesure (1) comprenant en outre :
- un processeur optique (13) comprenant un réseau neuronal profond diffractif entraîné étant un réseau neuronal artificiel, ANN (131), qui comprend un certain nombre de couches diffractives (1311) étant agencées en série pour une traversée par la lumière émanant du milieu pompé (11), et qui est configuré pour modifier la distribution spatiale de la lumière de façon à appliquer une transformation linéaire à la lumière émanant du milieu de captage pompé (11), dans lequel l'ANN (131) est entraîné en fonction de discordances entre des paires de motifs de lumière de sortie et des motifs de lumière souhaités ; et
- un détecteur optique (15) configuré pour détecter une propriété optique de la lumière transformée.

2. Système selon la revendication 1,
dans lequel la lumière émanant du milieu de captage (11) est de la lumière de pompage provenant de la pompe optique ou de la lumière de sondage provenant d'une autre source de lumière, passant à travers ou étant réfléchie respectivement par le milieu de captage (11).

3. Système (1) selon la revendication 1 ou 2, comprenant en outre
un générateur de champ (16) configuré pour exposer le milieu (11) à un champ électrique ou magnétique statique, dont une intensité définit un spectre d'absorption du milieu (11).

4. Système (1) selon l'une quelconque des revendications précédentes,
l'intensité du champ généré ayant un gradient le long d'une dimension spatiale (X) du milieu (11).

5. Système (1) selon la revendication 4,
le générateur de champ (16) comprenant un aimant permanent.

6. Système (1) selon l'une quelconque des revendications 1 à 5,
les couches diffractives (1311) étant établies par apprentissage supervisé avec des données d'entraînement marquées, et fabrication additive.

7. Système (1) selon la revendication 6,
le marquage des données d'entraînement tenant compte d'un ou plusieurs parmi :
- une sortie souhaitée de la transformation linéaire ;
- une focalisation de la lumière transformée sur le détecteur optique (15) ;
- un étalonnage ; et
- une correction d'erreurs.

8. Système (1) selon l'une quelconque des revendications 1 à 6,
le milieu (11) comprenant un métal alcalin enfermé dans une cellule de vapeur atomique (17) ;
l'au moins un constituant du milieu (11) comprenant des atomes ou ions dans un gaz tampon ; et la lumière émanant du milieu (11) pompé comprenant une transmission de lumière à travers le milieu (11) ayant une distribution d'intensité en coupe transversale dépendant d'une fréquence du champ électromagnétique du signal RF.

9. Système (1) selon l'une quelconque des revendications 1 à 6,
le milieu (11) comprenant un diamant à azote-lacune, NV ;
l'au moins un constituant du milieu (11) comprenant des défauts ponctuels ;
la lumière émanant du milieu (11) pompé comprenant une émission de lumière du milieu (11) ayant une distribution d'intensité directionnelle dépendant de la fréquence du champ électromagnétique du signal RF ; et
le système (1) comprenant en outre une lentille optique (132) configurée pour collimater la lumière émanant du milieu pompé (11) sur le processeur (13).

10. Système (1) selon l'une quelconque des revendications précédentes,
la pompe (12) comprenant au moins une source de lumière optique cohérente.

11. Système (1) selon l'une quelconque des revendications précédentes,
le détecteur (15) comprenant au moins une puce de dispositif à couplage de charge, CCD, ou puce CMOS, s'étendant à travers une coupe transversale de la lumière transformée ; et
la propriété optique détectée comprenant une distribution d'intensité en coupe transversale de la lumière transformée.

12. Procédé (2) d'analyse d'un signal RF, comprenant
- le pompage (21) d'au moins un constituant d'un milieu de captage (11) jusqu'à un état énergétique initial, l'au moins un constituant pouvant en outre être excité de l'état énergétique initial à un état énergétique supérieur par exposition à un champ électrique et/ou magnétique ;
- l'exposition (22) du milieu (11) à un champ électromagnétique du signal RF ;
dans lequel de la lumière émanant du milieu de captage pompé (11) a une distribution spatiale, qui dépend de la fréquence du signal RF ;
- l'application (23) d'une transformation linéaire à de la lumière émanant du milieu pompé (11) au moyen d'un processeur optique (13) comprenant un réseau neuronal profond diffractif entraîné étant un réseau neuronal artificiel, ANN (131), qui comprend un certain nombre de couches diffractives (1311) étant agencées en série pour une traversée par la lumière émanant du milieu pompé (11), et qui est configuré pour modifier la distribution spatiale de la lumière de façon à appliquer une transformation linéaire à la lumière émanant du milieu de captage pompé (11), dans lequel l'ANN (131) est entraîné en fonction de discordances entre des paires de motifs de lumière de sortie et des motifs de lumière souhaités ; et
- la détection (24) d'une propriété optique de la lumière transformée.
